# EUROPEAN PATENT SPECIFICATION

(11) **EP 1 400 858 B1**
(45) Date of publication and mention of the grant of the patent: **19.08.2009**
(21) Application number: 02743687.2
(22) Date of filing: 21.06.2002
(51) Int. Cl.: G03F 7/42

(54) **PHOTORESIST STRIPPER COMPOSITION**
FOTORESIST-ENTFERNUNGSZUSAMMENSETZUNG
COMPOSITION DE DECAPAGE DE PHOTORESINE

(30) Priority: 29.06.2001 JP 2001197935
(43) Date of publication of application: 24.03.2004
(73) Proprietor: MITSUBISHI GAS CHEMICAL COMPANY, INC., Tokyo 100-0005 (JP)
(72) Inventor: IKEMOTO, K., Mitsubishi Gas Chemical Co., Inc., Niigata-shi, Niigata 950-3112 (JP); ABE, H., Mitsubishi Gas Chemical Co., Inc., Niigata-shi, Niigata 950-3112 (JP); MARUYAMA, T., Mitsubishi Gas Chemical Co., Inc., Niigata-shi, Niigata 950-3112 (JP); AOYAMA, T., Mitsubishi Gas Chemical Co., Inc., Niigata-shi, Niigata 950-3112 (JP)
(74) Representative: Gille Hrabal Struck Neidlein Prop Roos
(86) International application number: PCT/JP2002/006216
(87) International publication number: WO 2003/003124

(56) References cited:
- EP-A- 1 031 884
- WO-A-87/05314
- GB-A- 2 340 256
- JP-A- 1 081 949
- JP-A- 9 244 263
- JP-A- 2001 022 095
- US-A- 5 102 777

## Description

### Technical Field

The present invention relates to a photoresist stripping composition for use in the wiring-forming process or electrode-forming process for producing semiconductor elements of semiconductor integrated circuits or liquid crystal displays, and relates to a process of producing semiconductor elements using the photoresist stripping composition.

### Background Art

Semiconductor integrated circuits have been generally produced by the steps of coating a photoresist composition onto a wiring thin film formed on an inorganic substrate to form a photoresist film; patterning the photoresist film by exposure to light and subsequent development to form a photoresist pattern; etching non-masked portions of the wiring thin film using the photoresist pattern as a mask to form fine circuits; and removing the photoresist film from the inorganic substrate having formed thereon the fine circuits. Alternatively, after forming the fine circuits in the same manner, the photoresist film is ashed and the remaining resist residues are removed from the inorganic substrate having formed thereon the fine circuits.

Japanese Patent Application Laid-Open Nos. 62-49355, 62-95531 and 5-273768 disclose water-free, organic amine-based stripping agents. However, the proposed organic amine-based stripping agents are extremely poor in the removing ability of the resist film after etching and the resist residue after etching/ashing.

Under the recent requirement for ultrafine circuits, the wiring materials are etched under more severe conditions, this being likely to change the quality of the photoresist being used. Also, the resist residue after etching/plasma ashing has a complicated chemical composition. Therefore, the proposed organic amine-based stripping agents have been found to be less effective for removing such resist films and resist residues.

In a dry etching, sidewall polymers, a kind of resist residues, are formed on the sidewall of etched portions by the interaction between dry etching gas, resist materials and various wiring materials. The known organic amine-based stripping agents mentioned above are also less effective for removing the sidewall polymers.

Japanese Patent Application Laid-Open Nos. 64-81949, 64-81950 and 6-266119 disclose water-containing, alkanol amine-based stripping agents. However, these water-containing, alkanol amine-based stripping agents are still insufficient for removing the above resist films, resist residues and sidewall polymers.

The semiconductor elements for semiconductor integrated circuits and liquid crystal displays are recently made of various materials. Therefore, a photoresist stripping agent that does not corrode the inorganic substrate and wiring that are made of various materials have been demanded to be developed.

### Disclosure of Invention

An object of the present invention is to solve the above problems in the conventional stripping agents, and to provide a resist stripping composition that is capable of easily removing photoresist films coated on a wiring thin film formed on an inorganic substrate, photoresist films remaining after etching the wiring thin film, and photoresist residues remaining after etching and subsequent ashing, at low temperatures in a short period of time without corroding the inorganic substrate and wiring made of various inorganic materials, thereby ensuring the fine processing for forming high precision circuits.

As a result of extensive researches in view of the above objects, the inventors have found a photoresist stripping composition that is capable of removing photoresist masks and resist residues remaining after etching and resist residues remaining after etching and subsequent ashing easily in a short period of time without corroding wiring and insulating film formed on an inorganic substrate, thereby ensuring the production of semiconductor fine circuits with a high precision. The present invention has been accomplished based on this finding.

Thus, the present invention provides a photoresist stripping composition according to claim 1. The photoresist stripping composition may further contain at least one of an organic solvent, an anti-corrosion agent and water.

### Brief Description of Drawings

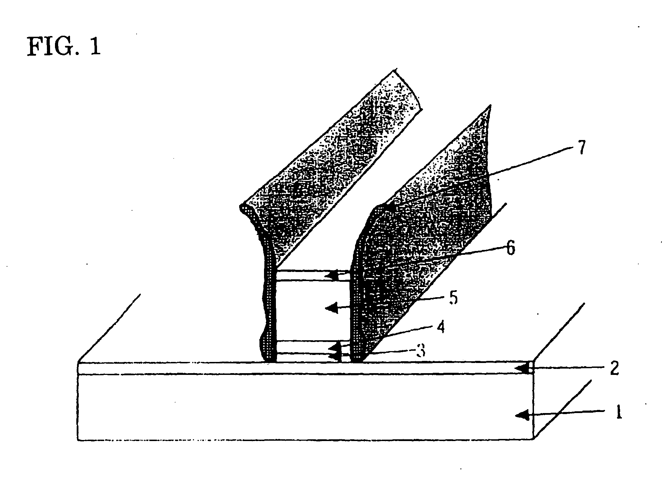

Fig. 1 is a partial cross-sectional view showing a semiconductor device obtained by forming Al-alloy wiring by dry etching using a resist film as a mask, and then, ashing by oxygen plasma.

### Best Mode for Carrying Out the Invention

The amine compound usable may include, for example, an alkylamine, an alkanolamine, a polyamine, a hydroxylamine compound and a cyclic amine.

Examples of the alkyl amines include primary alkylamines such as methylamine, ethylamine, n-propylamine, isopropylamine, n-butylamine, sec-butylamine, isobutylamine, t-butylamine, pentylamine, 2-aminopentane, 3-aminopentane, 1-amino-2-methylbutane, 2-amino-2-methylbutane, 3-amino-2-methylbutane, 4-amino-2-methylbutane, hexylamine, 5-amino-2-methylpentane, heptylamine, octylamine, nonylamine, decylamine, undecylamine, dodecylamine, tridecylamine, tetradecylamine, pentadecylamine, hexadecylamine, heptadecylamine, and octadecylamine; secondary alkylamines such as dimethylamine, diethylamine, dipropylamine, diisopropylamine, dibutylamine, diisobutylamine, di-sec-butylamine, di-t-butylamine, dipentylamine, dihexylamine, diheptylamine, dioctylamine, dinonylamine, didecylamine, methylethylamine, methypropylamine, methylisopropylamine, methylbutylamine, methylisobutylamine, methyl-sec-butylamine, methyl-t-butylamine, methylamylamine, methylisoamylamine, ethylpropylamine, ethylisopropylamine, ethylbutylamine, ethylisobutylamine, ethyl-sec-butylamine, ethyl-t-butylamine, ethylisoamylamine, propylbutylamine, and propylisobutylamine; and tertiary alkylamines such as trimethylamine, triethylamine, tripropylamine, tributylamine, tripentylamine, dimethylethylamine, methyldiethylamine, and methyldipropylamine.

Examples of the alkanolamines include ethanolamine, N-methylethanolamine, N-ethylethanolamine, N-propylethanolamine, N-butylethanolamine, diethanolamine, isopropanolamine, N-methylisopropanolamine, N-ethylisopropanolamine, N-propylisopropanolamine, 2-aminopropane-1-ol, N-methyl-2-aminopropane-1-ol, N-ethyl-2-aminopropane-1-ol, 1-aminopropane-3-ol, N-methyl-1-aminopropane-3-ol, N-ethyl-1-aminopropane-3-ol, 1-aminobutane-2-ol, N-methyl-1-aminobutane-2-ol, N-ethyl-1-aminobutane-2-ol, 2-aminobutane-1-ol, N-methyl-2-aminobutane-1-ol, N-ethyl-2-aminobutane-1-ol, 3-aminobutane-1-ol, N-methyl-3-aminobutane-1-ol, N-ethyl-3-aminobutane-1-ol, 1-aminobutane-4-ol, N-methyl-1-aminobutane-4-ol, N-ethyl-1-aminobutane-4-ol, 1-amino-2-methylpropane-2-ol, 2-amino-2-methylpropane-1-ol, 1-aminopentane-4-ol, 2-amino-4-methylpentane-1-ol, 2-aminohexane-1-ol, 3-aminoheptane-4-ol, 1-aminooctane-2-ol, 5-aminooctane-4-ol, 1-aminopropane-2,3-diol, 2-aminopropane-1,3-diol, tris(oxymethyl)aminomethane, 1,2-diaminopropane-3-ol, 1,3-diaminopropane-2-ol, and 2-(2-aminoethoxy)ethanol.

Examples of the polyamines include ethylenediamine, propylenediamine, trimethylenediamine, tetramethylenediamine, 1,3-diaminobutane, 2,3-diaminobutane, pentamethylenediamine, 2,4-diaminopentane, hexamethylenediamine, heptamethylenediamine, octamethylenediamine, nonamethylenediamine, N-methylethylenediamine, N,N-dimethylethylenediamine, trimethylethylenediamine, N-ethylethylenediamine, N,N-diethylethylenediamine, triethylethylenediamine, 1,2,3-triaminopropane, hydrazine, tris(2-aminoethyl)amine, tetra(aminomethyl)methane, diethylenetriamine, triethylenetetramine, tetraethylenepentamine, heptaethyleneoctamine, and nonaethylenedecamine.

Examples of the hydroxylamine compounds include hydroxylamine, N-methylhydroxylamine, N-ethylhydroxylamine, and N,N-diethylhydroxylamine.

Examples of the cyclic amines include pyrrole, 2-methylpyrrole, 3-methylpyrrole, 2-ethylpyrrole, 3-ethylpyrrole, 2,3-dimethylpyrrole, 2,4-dimethylpyrrole, 3,4-dimethylpyrrole, 2,3,4-trimethylpyrrole, 2,3,5-trimethylpyrrole, 2-pyrroline, 3-pyrroline, pyrrolidine, 2-methylpyrrolidine, 3-methylpyrrolidine, pyrazole, imidazole, 1,2,3-trizaole, 1,2,3,4-tetrazole, piperidine, 2-pipecoline, 3-pipecoline, 4-pipecoline, 2,4-lupetidine, 2,6-lupetidine, 3,5-lupetidine, piperazine, 2-methylpiperazine, 2,5-dimethylpiperazine, 2,6-dimethylpiperazine, and morpholine.

The amine compound usable in the present invention is not limited to the amines recited above, and any amine compounds are usable without specific limitation. The amine compounds may be used singly or in combination of two or more.

Of the amine compounds recited above, preferred are methylamine, ethylamine, propylamine, butylamine, ethanolamine, N-methylethanolamine, N-ethylethanolamine, diethanolamine, isopropanolamine, 2-(2-aminoethoxy)ethanol, ethylenediamine, propylenediamine, butylenediamine, diethylenetriamine, piperazine, and morpholine.

The organic solvent usable in the present invention is not specifically limited as far as miscible with a mixture of the alkanol amide compound and the amine compound, and preferably a water-soluble organic solvent.
Examples thereof include ether solvents such as ethylene glycol, ethylene glycol monoethyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monobutyl ether, dipropylene glycol monomethyl ether, dipropylene glycol monoethyl ether, dipropylene glycol monobutyl ether, diethylene glycol dimethyl ether and dipropylene glycol dimethyl ether; amide solvents such as formamide, monomethylformamide, dimethylformamide, monoethylformamide, diethylformamide, acetamide, monomethylacetamide, dimethylacetamide, monoethylacetamide, diethylacetamide, N-metylpyrrolidone and N-ethylpyrrolidone; alcohol solvents such as methyl alcohol, ethyl alcohol, isopropanol, ethylene glycol and propylene glycol; sulfoxide solvents such as dimethyl sulfoxide; sulfone solvents such as dimethyl sulfone, diethyl sulfone, bis(2-hydroxy) sulfone and tetramethylene sulfone; imidazolidinone solvents such as 1,3-dimethyl-2-imidazolidinone, 1,3-diethyl-2-imidazolidinone and 1,3-diisopropyl-2-imidazolidinone; and lactone solvents such as γ-butyrolactone and δ-valerolactone.

Of the above solvents, preferred are dimethyl sulfoxide, N,N-dimethylformamide, N,N-dimethylacetamide, N-methylpyrrolidone, diethylene glycol monomethyl ether, diethylene glycol monobutyl ether, dipropylene glycol monomethyl ether and dipropylene glycol monobutyl ether.

The photoresist stripping composition of the present invention may further contain an anti-corrosion agent. Examples thereof include phosphoric acid compounds such as 1,2-propanediaminetetramethylene phosphonic acid and hydroxyethane phosphonic acid; caboxylic acids such as ethylenediaminetetraacetic acid, dihydroxyethylglycine, nitrilotriacetic acid, oxalic acid, citric acid, malic acid and tartaric acid; amines such as bipyridine, tetraphenylporphyrin, phenanthroline and 2,3-pyridinediol; oxime compounds such as dimethylglyoxime and diphenylglyoxime; sugar alcohols such as sorbitol and xylitol; aromatic hydroxy compounds such as phenol, cresol, xylenol, pyrocatechol, resorcinol, hydroquinone, pyrogallol, 1,2,4-benzenetriol, salicyl alcohol, p-hydroxybenzyl alcohol, o-hydroxybenzyl alcohol, p-hydroxyphenetyl alcohol, p-aminophenol, m-aminophenol, diaminophenol, aminoresorcinol, p-hydroxybenzoic acid, o-hydroxybenzoic acid, 2,4-dihydroxybenzoic acid, 2,5-dihydroxybenzoic acid, 3,4-dihydroxybenzoic acid, 3,5-dihydroxybenzoic acid and gallic acid.

These compounds may be used alone or in combination of two or more.
Preferred anti-corrosion agent is the aromatic hydroxy compound, and catechol is more preferred in view of its low cost.

The mixing ratio (weight ratio) of the alkanol amide compound is 0.0001 to 50, preferably 0.005 to 20 based on the amine compound. The concentration of the amine compound in the photoresist stripping composition is 2 to 99.99% by weight, preferably 5 to 95% by weight.

The use of the organic solvent is not strictly limited. The concentration thereof can be determined depending on the viscosity and specific gravity of the photoresist stripping composition and the conditions of etching process and ashing process. If used, the concentration thereof may be up to 90% by weight of the photoresist stripping composition.

The addition amount of the anti-corrosion agent is not specifically limited, and preferably 30% by weight or less, more preferably 15% by weight or less of the photoresist stripping composition.

The photoresist stripping composition may further contain water. The addition amount of water is not specifically limited and may be determined depending on the etching conditions and ashing conditions. Preferably, the addition amount of water is 50% by weight or less of the photoresist stripping composition.

The inorganic substrate usable in the present invention may include silicon, amorphous silicon, polysilicon, and glass substrate for liquid crystal display. The wiring material may include semiconductor wiring materials such as silicon oxide, silicon nitride, copper, copper alloys, aluminum, aluminum alloys, titanium, titanium-tungsten, titanium nitride, tungsten, tantalum, tantalum compounds, chromium, chromium oxide, chromium alloys, indium-tin-oxide (ITO); and compound semiconductors such as gallium-arsenic, gallium-phosphorus and indium-phosphorus.

In the production method of a semiconductor element of the present invention, an inorganic substrate is provided thereon with a conductive thin film for circuits, which is then coated with a photoresist composition. The formed photoresist film is patterned by exposure to light. The non-masked portions of the conductive thin film is etched using the patterned photoresist film as a mask. Then, the remaining photoresist film is removed by the photoresist stripping composition mentioned above. After the etching, the ashing treatment may be employed, if desired. The photoresist residue remaining after the ashing treatment can be also removed by the photoresist stripping composition. The ashing treatment referred to herein is a resist removing method in which a photoresist made of an organic polymer is vaporized to CO and CO₂ by combustion in oxygen plasma.

The removal of the remaining photoresist film and photoresist residue by the photoresist stripping composition of the present invention is carried out by contacting the inorganic substrate having the remaining photoresist film and photoresist residue with the photoresist stripping composition at a temperature usually from ordinary temperature to 150°C. To prevent the materials for semiconductor elements form being attacked, the contacting operation is preferably carried out at a temperature as low as possible. By using the photoresist stripping composition of the present invention, the remaining photoresist film and photoresist residue can be removed at low temperatures, particularly, at 70°C or lower. The contacting operation is carried out by spray, application or immersion. The contacting time is preferably 0.5 to 60 min.

After removal using the photoresist stripping composition, the inorganic substrate having formed thereon circuits may be rinsed with an organic solvent such as alcohol or water, without specific limitation.

The present invention will be described in more detail with reference to the following examples. However, it should be noted that the scope of the present invention is not limited to the following examples.

In Fig. 1, is shown a partial cross-sectional view of a semiconductor device that is obtained by forming Al-alloy (Al-Cu) wiring 5 by dry etching using a photoresist film as a mask, and then, ashing by oxygen plasma. An oxide film 2 is formed on a silicon substrate 1, and the Al-alloy film 5 serving as wiring is formed on the oxide film 2. On the sidewalls of the Al-alloy film 5, a resist residue 7 remains. A titanium film 3 and titanium nitride films 4, 6 are further formed as barrier metals.

### EXAMPLES 1-12 AND COMPARATIVE EXAMPLES 1-3

The semiconductor device having the resist residue as shown in Fig. 1 was immersed in the photoresist stripping composition having each chemical composition shown in Tables 1-4 in a predetermined period of time, rinsed with a super pure water, dried, and then observed under a scanning electron microscope (SEM). The removal of the remaining photoresist film and resist residue, and the corrosion of the aluminum (Cl) wiring were evaluated. The results are shown in Table 1-4. In the following examples and comparative examples, the results of SEM observation was evaluated according to the following ratings.

### Removal

A: Completely removed.
B: Almost completely removed.
C: Partially remained unremoved.
D: Almost all remained unremoved.

### Corrosion

A: No corrosion was observed.
B: Almost no corrosion was observed.
C: Crater-like or pit-like corrosion was observed.
D: Whole surface of aluminum wiring was roughened, and Al-Cu layer was recessed.

**Table 1**

| | EXAMPLES | | | |
|---|---|---|---|---|
| | 1 | 2 | 3 | 4 |
| Amine | | | | |
| kind | ethanol | ethanol | ethanol | ethanol |
| | amine | amine | amine | amine |
| concentration (wt %) | 70 | 78 | 78 | 75 |
| Alkanol amide | | | | |
| kind* | MLAD | MLAD | MLFD | MLAD |
| concentration (wt %) | 3 | 5 | 5 | 8 |
| Organic solvent | | | | |
| kind* | DMSO | - | - | - |
| concentration (wt %) | 27 | - | - | - |
| Anti-corrosion agent | | | | |
| kind | - | catechol | catechol | catechol |
| concentration (wt %) | - | 5 | 5 | 5 |
| H₂O | | | | |
| concentration (wt %) | - | 12 | 12 | 12 |
| Stripping conditions | | | | |
| temperature (°C) | 55 | 55 | 55 | 55 |
| time (min) | 10 | 3 | 3 | 5 |
| Stripping | A | A | A | A |
| Corrosion | A | A | A | A |

| | | | | |
|---|---|---|---|---|
| Note: MLAD = N-methylol acetamide MLFD = N-methylol formamide DMSO = dimethylsulfoxide | | | | |

**Table 2**

| | EXAMPLES | | | |
|---|---|---|---|---|
| | 5 | 6 | 7 | 8 |
| Amine | | | | |
| kind | ethanol | ethanol | ethylene | N-methyl |
| | amine | amine | diamine | ethanolamine |
| concentration (wt %) | 75 | 65 | 50 | 78 |
| Alkanol amide | | | | |
| kind* | HEAD | MLAD | MLAD | MLAD |
| concentration (wt %) | 8 | 5 | 5 | 5 |
| Organic solvent | | | | |
| kind* | - | DGBE | DGBE | - |
| concentration (wt %) | - | 15 | 30 | - |
| Anti-corrosion agent | | | | |
| kind | catechol | catechol | EDTA | catechol |
| concentration (wt %) | 5 | 3 | 3 | 5 |
| H₂O | | | | |
| concentration (wt %) | 12 | 12 | 12 | 12 |
| Stripping conditions | | | | |
| temperature (°C) | 55 | 55 | 50 | 55 |
| time (min) | 5 | 5 | 3 | 10 |
| Stripping | A | A | A | A |
| Corrosion | A | A | A | A |

| | | | | |
|---|---|---|---|---|
| Note: HEAD = N-(1-hydroxyethyl) acetamide MLAD = N-methylol acetamide DGBE = diethylene glycol monobutyl ether EDTA = ethylenediaminetetraacetic acid | | | | |

**Table 3**

| | EXAMPLES | | | |
|---|---|---|---|---|
| | 9 | 10 | 11 | 12 |
| Amine | | | | |
| kind | ethanol | ethanol | ethanol | ethanol |
| | amine | amine | amine | amine |
| concentration (wt %) | 65 | 40 | 73 | 65 |
| Alkanol amide | | | | |
| kind* | MLAD | HEAD | HEAD | HEAD |
| concentration (wt %) | 5 | 5 | 10 | 5 |
| Organic solvent | | | | |
| kind* | DMSO | DGBE | - | DMAC |
| concentration (wt %) | 15 | 40 | - | 15 |
| Anti-corrosion agent | | | | |
| kind | catechol | catechol | catechol | catechol |
| concentration (wt %) | 3 | 3 | 5 | 3 |
| H₂O | | | | |
| concentration (wt %) | 12 | 12 | 12 | 12 |
| Stripping conditions | | | | |
| temperature (°C) | 55 | 55 | 55 | 55 |
| time (min) | 5 | 10 | 5 | 10 |
| Stripping | A | A | A | A |
| Corrosion | A | A | A | A |

| | | | | |
|---|---|---|---|---|
| Note: MLAD = N-methylol acetamide HEAD = N-(1-hydroxyethyl) acetamide DMSO = dimethylsulfoxide DGBE = diethylene glycol monobutyl ether DMAC = dimethyl acetamide | | | | |

**Table 4**

| | COMPARATIVE EXAMPLES | | | |
|---|---|---|---|---|
| | 1 | 2 | 3 | 4 |
| Amine | | | | |
| kind | ethanol | ethanol | ethanol | N-methyl |
| | amine | amine | amine | ethanolamine |
| concentration (wt %) | 70 | 78 | 65 | 78 |
| Alkanol amide | | | | |
| kind* | - | - | - | - |
| concentration (wt %) | - | - | - | - |
| Organic solvent | | | | |
| kind* | DMSO | - | DGBE | - |
| concentration (wt %) | 30 | - | 15 | - |
| Anti-corrosion agent | | | | |
| kind | - | catechol | catechol | catechol |
| concentration (wt %) | - | 5 | 3 | 5 |
| H₂O | | | | |
| concentration (wt %) | - | 17 | 17 | 17 |
| Stripping conditions | | | | |
| temperature (°C) | 55 | 55 | 55 | 55 |
| time (min) | 10 | 3 | 5 | 10 |
| Stripping | C | B | C | D |
| Corrosion | A | B | B | A |

| | | | | |
|---|---|---|---|---|
| Note: DMSO = dimethylsulfoxide DGBE = diethylene glycol monobutyl ether | | | | |

### Industrial Applicability

By using the photoresist stripping composition of the present invention, the resist residue remaining after dry etching using a reactive gas and ashing can be quite easily removed without corroding the wiring material, etc.

## Claims

1. A photoresist stripping composition comprising an amine compound and at least one alkanol amide compound selected from the group consisting of N-methylol acetamide, N-methylol formamide, N-(1-hydroxyethyl) acetamide, N-(1-hydroxyethyl) formamide, N-methylol urea, N,N'-dimethylol urea, N-methylol acrylamide and N-methylol methacrylamide.

2. The photoresist stripping composition according to Claim 1, wherein the amine compound is an alkylamine, an alkanolamine, a polyamine, a hydroxylamine compound or a cyclic amine.

3. The photoresist stripping composition according to Claim 1 or 2, further comprising an organic solvent.

4. The photoresist stripping composition according to any one of Claims 1 to 3, further comprising an anti-corrosion agent.

5. The photoresist stripping composition according to Claim 4, wherein the anti-corrosion agent is an aromatic hydroxy compound.

6. The photoresist stripping composition according to Claim 5, wherein the anti-corrosion agent is catechol.

7. The photoresist stripping composition according to any one of Claims 1 to 6, further comprising water.

8. A method for producing a semiconductor element, comprising the steps of:
(1) coating a photoresist composition onto a wiring thin film formed on an inorganic substrate to form a photoresist film;
(2) patterning the photoresist film by exposure to light and subsequent development to form a photoresist pattern;
(3) etching non-masked portions of the wiring thin film using the photoresist pattern as a mask to obtain the inorganic substrate having formed thereon fine circuits; and
(4) removing the remaining photoresist pattern by contacting the inorganic substrate having formed thereon fine circuits with the photoresist stripping composition as defined in any one of Claims 1 to 7 at a temperature from ordinary temperature to 150°C.

## Patentansprüche

1. Photoresist-Entfernungs-Zusammensetzung, umfassend eine Aminverbindung und mindestens eine Alkanolamidverbindung, ausgewählt aus der aus N-Methylolacetamid, N-Methylolformamid, N-(1-Hydroxyethyl)acetamid, N-(1-Hydroxyethyl)formamid,
N-Methylolharnstoff, N,N'-Dimethylolharnstoff, N-Methylolacrylamid und N-Methylolmethacrylamid bestehenden Gruppe.

2. Photoresist-Entfernungs-Zusammensetzung nach Anspruch 1 , wobei die Aminverbindung ein Alkylamin, ein Alkanolamin, ein Polyamin, eine Hydroxylaminverbindung oder ein cyclisches Amin ist.

3. Photoresist-Entfernungs-Zusammensetzung nach Anspruch 1 oder 2, darüber hinaus umfassend ein organisches Lösungsmittel.

4. Photoresist-Entfernungs-Zusammensetzung nach einem der Ansprüche 1 bis 3, darüber hinaus umfassend ein Anti-Korrosionsmittel,

5. Photoresist-Entfernungs-Zusammensetzung nach Anspruch 4, wobei das Anti-Korrosionsmittel eine aromatische Hydroxyverbindung ist.

6. Photoresist-Entfernungs-Zusammensetzung nach Anspruch 5, wobei das Anti-Korrosionsmittel Catechol ist.

7. Photoresist-Entfernungs-Zusammensetzung nach einem der Ansprüche 1 bis 6, darüber hinaus umfassend Wasser.

8. Verfahren zur Herstellung eines Halbleiterelements, umfassend die Schritte:
(1) Beschichten eines Verdrahtungsdünnfilms, der auf einem anorganischen Substrat gebildet ist, mit einer Photoresist-Zusammensetzung zur Bildung eines Photoresist-Films;
(2) Musterbildung im Photoresist-Film durch Belichten mit Licht und anschließend Entwickeln zur Bildung eines Photoresist-Musters;
(3) Ätzen nicht-maskierter Bereiche des Verdrahtungsdünnfilms unter Verwendung des Photoresist-Musters als Maske, um das anorganische Substrat mit darauf ausgebildeten feinen Schaltkreisen zu erhalten; und
(4) Entfernen des verbliebenen Photoresist-Musters durch In-Kontakt-Bringung des anorganischen Substrats mit den darauf ausgebildeten feinen Schaltkreisen mit der wie in einem der Ansprüche 1 bis 7 definierten Photoresist-Entfernungs-Zusammensetzung bei einer Temperatur von Raumtemperatur bis 1 50°C.

## Revendications

1. Composition de décapage de photorésine comprenant un composé amine et au moins un composé d'alcanolamide sélectionné dans le groupe composé de N-méthylolacétamide, de N-méthylolformamide, de N-(1-hydroxyéthyle)-acétamide, de N-(1-hydroxyéthyle)-formamide, de N-méthylolurée, de N,N'-diméthylolurée, de N-méthylolacrylamide et de N-méthylolméthacrylamide.

2. Composition de décapage de photorésine selon la revendication 1, dans laquelle le composé amine est un alkylamine, un alcanolamine, une polyamine, un composé hydroxylamine ou une amine cyclique.

3. Composition de décapage de photorésine selon la revendication 1 ou 2, comprenant en outre un solvant organique.

4. Composition de décapage de photorésine selon l'une quelconque des revendications 1 à 3, comprenant en outre un agent anticorrosion.

5. Composition de décapage de photorésine selon la revendication 4, dans laquelle l'agent anti-corrosion est un composé hydroxy aromatique.

6. Composition de décapage de photorésine selon la revendication 5, dans laquelle l'agent anti-corrosion est du catéchol.

7. Composition de décapage de photorésine selon l'une quelconque des revendications 1 à 6, comprenant en outre de l'eau.

8. Procédé de production d'un élément semiconducteur, comprenant les étapes consistant à :
(1) étaler une composition de photorésine sur un film de câblage mince formé sur un substrat inorganique afin de former un film de photorésine ;
(2) modeler le film de photorésine par exposition à la lumière et développement ultérieur afin de former un motif de photorésine ;
(3) graver des parties non masquées du film de câblage mince en utilisant le motif de photorésine comme masque afin d'obtenir le substrat inorganique sur lequel sont formés de fins circuits ; et.
(4) retirer le motif de photorésine restant par la mise en contact du substrat inorganique sur lequel sont formés les fins circuits avec la composition de décapage de photorésine telle que définie dans l'une quelconque des revendications 1 à 7 à une température allant d'une température ordinaire à 150°C.
